# EUROPÄISCHE PATENTSCHRIFT

(11) **EP 3 802 387 B1**
(45) Veröffentlichungstag und Bekanntmachung des Hinweises auf die Patenterteilung: **24.11.2021**
(21) Anmeldenummer: 19727360.0
(22) Anmeldetag: 28.05.2019
(51) Int. Cl.: C23C 14/56, C23C 14/16, C23C 14/02, C23C 16/54, B65H 23/02, B65H 23/032, B65H 35/02

(54) **VAKUUMBESCHICHTUNGSANLAGE, UND VERFAHREN ZUM BESCHICHTEN EINES BANDFÖRMIGEN MATERIALS**
VACUUM-COATING SYSTEM AND METHOD FOR COATING A STRIP-TYPE MATERIAL
INSTALLATION DE REVÊTEMENT SOUS VIDE ET PROCÉDÉ POUR MUNIR UN MATÉRIAU EN FORME DE BANDE D'UN REVÊTEMENT

(30) Priorität: 28.05.2018 DE 102018208337; 05.09.2018 DE 102018215101
(43) Veröffentlichungstag der Anmeldung: 14.04.2021
(73) Patentinhaber: SMS Group GmbH, 40237 Düsseldorf (DE)
(72) Erfinder: KÜMMEL, Lutz, 41363 Jüchen (DE); DAUBE, Thomas, 47279 Duisburg (DE)
(74) Vertreter: Kross, Ulrich
(86) Internationale Anmeldenummer: PCT/EP2019/063720
(87) Internationale Veröffentlichungsnummer: WO 2019/229017

(56) Entgegenhaltungen:
- WO-A1-2012/034587
- DE-A1-102016 223 743
- JP-A- 2008 031 505
- US-A1- 2011 241 239

## Beschreibung

Die Erfindung betrifft eine Vakuumbeschichtungsanlage nach dem Oberbegriff von Anspruch 1, und ein Verfahren zum Beschichten eines bandförmigen Materials nach dem Oberbegriff von Anspruch 6.

Bei der Herstellung von Stahlbändern kommt es sowohl beim Warmwalzen als auch beim Kaltwalzen zu Breitenänderungen des Bandes über der Länge. Dies wird durch die sogenannte "Breitung" verursacht, welche eine Zunahme der Breite des gewalzten Bandes von einigen Millimetern durch den Walzstich zur Folge hat. Die unterschiedliche Breitung über der Länge des Stahlbandes ist in der Regel auf Zugschwankungen innerhalb der Anlage, mit der das Stahlband bearbeitet wird, zurückzuführen.

Eine weitere Problematik beim Walzen von Stahlbändern besteht darin, dass durch den Walzprozess Rand- oder Mittelwellen durch unterschiedliche Verlängerung über den Querschnitt entstehen können.

Bei der Herstellung von bandförmigen Material, z.B. in Form von Stahlbändern, ist es nach dem Stand der Technik bekannt, die Oberflächen dieses bandförmigen Materials zu verzinken. Dies kann durch einen Vakuumbedampfungsprozess erfolgen, wie z.B. aus DE 30 35 000 A1, DE 195 27 515 C1 oder DE 197 35 603 C1 bekannt. Zu diesem Vakuumbedampfungsprozess zählt auch die sogenannte PVD- Technologie, die z.B. in der DE 10 2009 053 367 A1 erläutert ist.

Bei dem vorstehend genannten Vakuumbedampfungsprozess erfolgt das Beschichten des bandförmigen Materials in Vakuum, wobei das bandförmige Material durch eine Schleuse und/oder ein System von Blendenelementen einer Kammer oder dergleichen zugeführt wird, in der Vakuum besteht bzw. erzeugt ist. Die Abdichtung des in der Kammer erzeugten Vakuums gegenüber der Umgebung erfolgt in der Regel über Dichtmittel in Form von Blendenelementen, was z.B. in der WO 2008/049523 A1 im Zusammenhang mit einer Bandschleuse beschrieben ist. Eine solche Abdichtung kann gemäß EP 1 004 369 B1 auch durch eine Schleuse mit einer Mehrzahl von Walzen realisiert werden, wobei zumindest eine Walze in Bezug auf mindestens zwei andere Walzen versetzt angeordnet ist und mit ihrer Distanz zu diesen zwei anderen Walzen eingestellt werden kann, um eine Abdichtung für das bandförmige Material, das zwischen diesen Walzen hindurchbewegt wird, zu erreichen.

Aus JP 2008 031 505 A ist es bekannt, ein bandförmiges Material mit seiner Breitenerstreckung in vertikaler Ausrichtung durch eine Vakuum-Beschichtungskammer hindurchzuführen. Durch ein Verschwenken von Walzen, um die das bandförmige Material für ein Bewegen in einer Transportrichtung herumgeführt ist, wird erreicht, dass das bandförmige Material eine schräg nach oben gerichtete Kraft erfährt, um ein Durchhängen in Folge seiner Gewichtskraft und die Bildung von Falten zu verhindern.

Falls ein bandförmiges Material nach dem Prinzip des Vakuumbedampfungsprozess beschichtet wird, kommt der Abdichtung des Vakuums gegenüber der Umgebung eine große Bedeutung zu. Zu diesem Zweck weist die Vakuumkammer, in der die Beschichtung des bandförmigen Materials realisiert wird, an der Einlassseite und Auslassseite jeweils Schleusen auf. Beim Transport des bandförmigen Materials durch die Vakuumkammer entstehen zwischen den Innenwänden der Schleusen und den äußeren Bandkanten des bandförmigen Materials jeweils seitliche Spalte. Zur Minimierung dieser Spalte ist es wichtig, die genaue Breite des bandförmigen Materials über seine Länge zu kennen. Sofern das bandförmige Material über seiner Länge eine ungleichmäßige Breite zeigt, kann dies im Bereich der Schleusen der Vakuumkammer entweder zu einem erhöhten Verschleiß oder gar zu einem Einbruch des Vakuums führen, wodurch der Beschichtungsprozess unter Vakuum gestört wird.

DE 10 2016 223 743 A1 bildet gattungsgemäßen Stand der Technik und zeigt eine Vakuumbeschichtungsanlage nach dem Oberbegriff von Anspruch 1 bzw. ein zugehöriges Verfahren nach dem Oberbegriff von Anspruch 6.

Entsprechend liegt der Erfindung die Aufgabe zugrunde, das Beschichten von bandförmigem Material unter Vakuum mit einfachen Mitteln zu optimieren und hierfür eine verbesserte Prozesssicherheit zu erreichen.

Diese Aufgabe wird durch eine Vakuumbeschichtungsanlage gemäß Anspruch 1 und durch ein Verfahren mit den in Anspruch 6 angegebenen Merkmalen gelöst. Vorteilhafte Weiterbildungen der Erfindung sind in den abhängigen Ansprüchen definiert.

Eine Vakuumbeschichtungsanlage nach der vorliegenden Erfindung dient zum Beschichten eines bandförmigen Materials insbesondere aus Metall, und umfasst eine Förderstrecke mit Transportmitteln insbesondere in Form von Walzen, auf denen das bandförmige Material mit seiner Breitenerstreckung in horizontaler Ausrichtung in einer Transportrichtung bewegt werden kann, und eine Beschichtungskammer, in der Vakuum erzeugbar ist. Hierbei weist die Beschichtungskammer einen Einlassbereich und einen Auslaufbereich auf, durch welche die Beschichtungskammer von dem bandförmigen Material entlang bzw. auf der Förderstrecke in der Transportrichtung durchlaufen werden kann. Zumindest eine Besäumschere ist - in Transportrichtung des bandförmigen Materials gesehen - stromaufwärts der Beschichtungskammer angeordnet, wobei das bandförmige Material mittels dieser Besäumschere an zumindest einer Bandkante, vorzugsweise an beiden Bandkanten, besäumt wird, um für das bandförmige Material über dessen Längenerstreckung eine konstante Breite zu erzeugen. In Transportrichtung des bandförmigen Materials 11 gesehen ist stromaufwärts der Besäumschere eine Bandlagenregeleinrichtung angeordnet, mit der das bandförmige Material in Bezug auf die Mitte der Förderstrecke ausrichtbar ist.

In gleicher Weise sieht die Erfindung auch ein Verfahren zum Beschichten eines bandförmigen Materials insbesondere aus Metall vor, bei dem das bandförmige Material mit seiner Breitenerstreckung in horizontaler Ausrichtung über eine Förderstrecke in einer Transportrichtung bewegt und innerhalb einer Beschichtungskammer, in der ein Vakuum angelegt ist, vakuumbeschichtet wird. Hierbei wird das bandförmige Material - in Transportrichtung des bandförmigen Materials gesehen - stromaufwärts der Beschichtungskammer an zumindest einer Bandkante, vorzugsweise an beiden Bandkanten besäumt bzw. beschnitten, um für das bandförmige Material über dessen Längenerstreckung eine konstante Breite zu erzeugen. Das bandförmige Material wird durch eine Bandlagenregeleinrichtung, die - in Transportrichtung des bandförmigen Materials gesehen - stromaufwärts der Besäumschere angeordnet ist, in Bezug auf die Mitte der Förderstrecke ausgerichtet.

Der Erfindung liegt die wesentliche Erkenntnis zugrunde, dass ein bandförmiges Material, bevor es in die unter Vakuum gesetzte Beschichtungskammer einer Vakuumbeschichtungsanlage einläuft, besäumt wird, um eine gleichbleibende Breite des bandförmigen Materials über dessen Länge zu erreichen. Falls das bandförmige Material z.B. durch Breitung verursacht eine ungleichmäßige Breite über seiner Länge aufweisen sollte, kann dies durch das Besäumen, das erfindungsgemäß vor bzw. stromaufwärts des Einlassbereichs der Beschichtungskammer durchgeführt wird, kompensiert werden. Das Besäumen findet entweder an einer der beiden Bandkanten bzw. seitlichen Ränder des bandförmigen Materials statt, oder - je nach Breitenabweichung - an beiden Bandkanten davon.

Die Installation von zumindest einer Besäumschere vor bzw. stromaufwärts des Einlassbereichs der Beschichtungskammer der Vakuumbeschichtungsanlage, mit der - nach Bedarf - ein entsprechendes Besäumen des bandförmigen Materials durchgeführt wird, führt erfindungsgemäß zu dem Vorteil, dass damit eine Bandbreite passend zum Endprodukt und optimal für den nachfolgenden Beschichtungsvorgang, der innerhalb der Beschichtungskammer realisiert wird, eingestellt wird. Insbesondere wird durch dieses Besäumen des bandförmigen Materials hierfür eine vorbestimmte Breite erzielt, die exakt mit der Breite der Einlaufschleuse und Auslaufschleuse übereinstimmt.

Ein weiterer Vorteil des Besäumens der Bandkanten des bandförmigen Materials stromaufwärts der Einlassseite der Beschichtungskammer besteht darin, dass damit die (besäumten) Bandkanten des bandförmigen Materials bei dem nachfolgenden Beschichtungsprozess unter Vakuum ebenfalls beschichtet, z.B. verzinkt werden.

In vorteilhafter Weiterbildung der Erfindung ist zumindest ein Positionssensor vorgesehen, mit dem eine Position des bandförmigen Materials auf der Förderstrecke in einem Bereich - in Transportrichtung des bandförmigen Materials gesehen - stromaufwärts der Beschichtungskammer bestimmt werden kann. Zweckmäßigerweise ist die Vakuumbeschichtungsanlage auch mit einer Steuerungseinrichtung ausgestattet, mittels der die Besäumschere in Abhängigkeit von Signalen des Positionssensors betätigt bzw. angesteuert werden kann. Dies bedeutet, dass die Besäumschere nur für den Fall in Aktion gesetzt wird, falls von dem Positionssensor erkannt wird, dass die Breite des bandförmigen Materials von einem vorbestimmten Wert abweicht und deshalb ein Besäumen mittels der Besäumschere erforderlich ist. Wie bereits erläutert, kann dieses Besäumen entweder nur an einem Seitenrand bzw. an einer Bandkante des bandförmigen Materials, oder aber beiderseits, d.h. an beiden Bandkanten (d.h. links und rechts) erfolgen.

Weitere Abweichungen des bandförmigen Materials von vorbestimmten Sollwerten können durch Planheitsfehler vorliegen, die z.B. bei vorgelagerten Wärmebehandlungsprozessen im Heizbereich und in der Kühlzone entstehen. Weiterhin können durch den Walzprozess Rand - oder Mittelwellen durch eine unterschiedliche Verlängerung über den Querschnitt entstehen, was ebenfalls zu Planheitsfehler führt. Diesbezüglich liegt es auf der Hand, dass solche Planheitsfehler ebenfalls zu Problemen im Bereich der Schleusen der Beschichtungskammer führen können, was zu einer erhöhten Leckage oder gar bis zum Einbruch des Vakuums führen kann.

Dadurch, dass - in Transportrichtung des bandförmigen Materials gesehen - vorzugsweise unmittelbar stromaufwärts der Besäumschere eine Bandlagenregeleinrichtung angeordnet ist, mit der das bandförmige Material in Bezug auf die Mitte der Förderstrecke ausgerichtet werden kann, ist gewährleistet, dass das bandförmige Material in Bezug auf seine Seitenränder stets gleichförmig in den Wirkbereich bzw. die Schneidmesser der Besäumschere einläuft, so dass dann mit einem Beschneiden des bandförmigen Materials hierfür eine gleichbleibende Breite über dessen Länge erzielt wird. Die Positionierung der Bandlagenregeleinrichtung unmittelbar vor der Besäumschere bewirkt auch, dass das bandförmige Material, nachdem es diese Bandlagenregeleinrichtung passiert hat, dann direkt in den Wirkbereich der Besäumschere einläuft und somit auf der Förderstrecke, im Bereich stromaufwärts bzw. vor der Besäumschere, quer bzw. senkrecht zur Transportrichtung nicht weiter verlaufen kann.

Zur Kompensation der vorstehend genannten Planheitsfehler sieht eine vorteilhafte Weiterbildung der Erfindung vor, dass - in Transportrichtung des bandförmigen Materials gesehen - stromaufwärts der zumindest einen Besäumschere zumindest eine Dressiergerüsteinrichtung und/oder eine Streck-/Biegeeinrichtung angeordnet ist, durch die das bandförmige Material hindurchgeführt wird, um für das bandförmige Material eine gewünschte Planheit zu erzeugen. Hierdurch ist es möglich, dass das bandförmige Material, bevor es durch die Einlaufschleuse in die Beschichtungskammer einläuft, eine gewünschte Planheit erhält, die insbesondere an die Ausgestaltung von Dichtelementen der Einlaufschleuse angepasst ist.

Optional kann vorgesehen sein, dass mittels der Dressiergerüsteinrichtung auch eine erforderliche Oberflächenrauheit für das bandförmige Material eingestellt wird, bevor es dann zum Aufbringen der Beschichtung in die Vakuum-Beschichtungskammer einläuft.

Mit der vorliegenden Erfindung lässt sich vorteilhaft eine Beschichtung von bandförmigem Material unter Vakuum realisieren, das aus Stahlband besteht und einen Gefügeanteil von mindestens 10% Martensit aufweist. Ein solches Stahlband kann weiterhin 0,1 - 0,4% Kohlenstoff, 0,5 - 2,0 % Silizium und/oder 1,5-3,0% Mangan enthalten. Solche Stähle können als "Dualphasenstähle" (DP), "Komplexphasenstahl" (CP), "Quenching and Partitioning Stähle" (Q&P) oder als "Martensitische Stähle" (MS) vorliegen, die jeweils einen unterschiedlichen Gehalt an Martensiten (mit zumindest 10%) haben.

Nachstehend ist eine bevorzugte Ausführungsform der Erfindung anhand einer schematisch vereinfachten Zeichnung im Detail beschrieben. Es zeigen:
- Fig. 1: eine schematisch vereinfachte Seitenansicht einer erfindungsgemäßen Anlage, mit der auch ein Verfahren nach der vorliegenden Erfindung durchgeführt werden kann, und
- Fig. 2: eine Draufsicht auf ein bandförmiges Material, das erfindungsgemäß an seinen Bandkanten besäumt wird.

Die vorliegende Erfindung sieht eine Vakuumbeschichtungsanlage 10 vor, mit der ein bandförmiges Material 11 an zumindest einer Seite davon, vorzugsweise an beiden Seiten (Oberseite und Unterseite) mit einer Beschichtung versehen werden kann. Entsprechend kann mit einer solchen Vakuumbeschichtungsanlage 10 auch ein Verfahren durchgeführt werden, um das bandförmige Material 11 insbesondere zu beschichten. Gleiche Merkmale in den beiden Figuren der Zeichnung sind jeweils mit gleichen Bezugszeichen versehen. An dieser Stelle wird gesondert darauf hingewiesen, dass die Zeichnung lediglich vereinfacht und insbesondere ohne Maßstab dargestellt ist.

Das bandförmige Material 11 kann aus Metall bestehen, insbesondere aus Stahl oder Edelstahl oder entsprechenden Legierungen hiervon. Des Weiteren wird darauf hingewiesen, dass es sich bei dem bandförmigen Material 11, welches mit der Vakuumbeschichtungsanlage 10 beschichtet wird, um Warmband oder Kaltband handeln kann.

Nachfolgend sind die Vakuumbeschichtungsanlage 10, die einzelnen Komponenten hiervon und deren Funktionsweise im Detail erläutert:
Die Vakuumbeschichtungsanlage 10 umfasst eine Förderstrecke 12 mit (nicht gezeigten) Transportmitteln, z.B. in Form von Walzen, auf denen das bandförmige Material in einer Transportrichtung T bewegt wird. Hierbei wird das bandförmige Material 11 am Einlauf der Förderstrecke 12 von einer ersten Haspeleinrichtung 46 abgewickelt, wobei das bandförmige Material 11 - nach Durchführung bzw. Abschluss der gewünschten Beschichtung - am Auslauf der Förderstrecke 12 von einer zweiten Haspeleinrichtung 48 wieder aufgewickelt wird. Direkt nach der ersten Haspeleinrichtung 46 und vor der zweiten Haspeleinrichtung 48 können (Band-)Speicher 44 vorgesehen sein, mit bzw. in denen das bandförmige Material 11 gespeichert werden kann. Innerhalb der Förderstrecke 12 wird das bandförmige Material 11 in der Bewegungsrichtung T bewegt bzw. transportiert, nämlich von der ersten Haspeleinrichtung 46 in Richtung der zweiten Haspeleinrichtung 48.

Entlang der Förderstrecke 12 ist eine Beschichtungskammer 14 angeordnet, durch die hindurch das bandförmige Material 11 bewegt wird. Zu diesem Zweck weist die Beschichtungskammer 14 einen Einlassbereich 16 und einen Auslassbereich 18 auf, wobei in dem Einlassbereich 16 eine Einlaufschleuse 20 und in dem Auslaufbereich 18 eine Auslaufschleuse 22 vorgesehen sind. In der Beschichtungskammer 14 wird Vakuum erzeugt. Hierbei gewährleisten die Einlaufschleuse 20 und die Auslaufschleuse 22 eine geeignete Abdichtung dieses Vakuums gegenüber der äußeren Umgebung, bei gleichzeitiger Bewegung des bandförmigen Materials 11 entlang der Förderstrecke 12 bzw. durch diese beiden Schleusen 20, 22 hindurch.

Die Beschichtungskammer 14 ist mehrteilig ausgebildet und weist einen Beschichtungsteil 26 und einen Reinigungsteil 28 auf. Beide dieser Teile 26 und 28 sind - wie vorstehend bereits erläutert - unter Vakuum gesetzt. In dem Beschichtungsteil 26 wird das eigentliche Beschichten des bandförmigen Materials 11 durchgeführt, z.B. nach dem Prinzip der "PVD" (= *physical vapor deposition),* an entweder einer Seite des bandförmigen Materials oder an beiden Seiten hiervon.

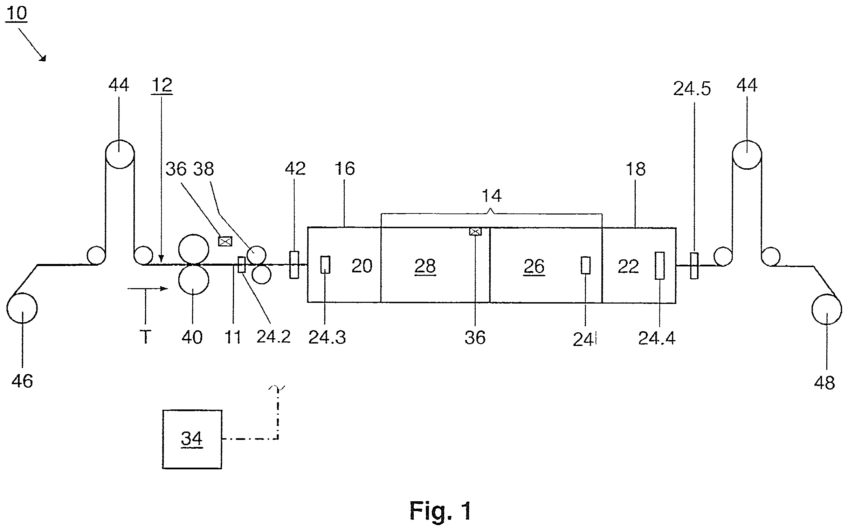

Innerhalb der Beschichtungskammer 14 kann zumindest eine Bandlagenregeleinrichtung 24 angeordnet sein, z.B. innerhalb des Beschichtungsteil 26, wie in der Fig. 1 gezeigt. Ergänzend oder alternativ ist es möglich, eine solche Bandlagenregeleinrichtung 24 in dem Reinigungsteil 28 anzuordnen.

Die Vakuumbeschichtungsanlage 10 umfasst eine Steuerungseinrichtung (in Fig. 1 nur vereinfacht durch ein Blocksymbol mit dem Bezugszeichen "34" gezeigt), die in Signalverbindung (drahtgebunden, oder drahtlos z.B. über eine Funkstrecke oder dergleichen) mit zumindest einem Positionssensor 36 steht. Dieser Positionssensor 36 kann in der Beschichtungskammer 14 angeordnet sein, zwecks Bestimmung der Position des bandförmigen Materials 11 auf der Förderstrecke 12 insbesondere in Bezug auf deren Mittenbereich.

Mittels einer Bandlagenregeleinrichtung 24 ist es möglich, eine Position des bandförmigen Materials 11 in Bezug auf eine Mitte der Förderstrecke 12 einzustellen bzw. auszurichten. Dies erfolgt dadurch, dass eine Position des bandförmigen Materials 11 auf der Förderstrecke 12 durch den Positionssensor 36 innerhalb der Beschichtungskammer 14 detektiert wird, wobei anschließend - bei Bedarf - (nicht gezeigte) Stellglieder der Bandlagenregeleinrichtung 24 durch die Steuerungseinrichtung 34 angesteuert werden, um das bandförmige Material 11 in Bezug auf die Mitte der Förderstrecke 12 und senkrecht zur Transportrichtung T auszurichten. Bei den Stellgliedern der Bandlagenregeleinrichtung 24 kann es sich entweder um Kontaktrollen handeln, die seitlich an die Ränder des bandförmigen Materials 11 angestellt werden. Ergänzend und/oder alternativ können diese Stellglieder in Form von Steuerrollen ausgebildet sein, über die das bandförmige Material 11 entlang der Transportrichtung T bewegt wird und mit denen das bandförmige Material 11 einen Umschlingungswinkel einschließt. Mit solchen Steuerrollen erfolgt das Ausrichten des bandförmigen Materials 11 in Bezug auf die Mitte der Förderstrecke 12 dann entweder dadurch, dass eine Steuerrolle mit ihrer Längsachse senkrecht zur Transportrichtung verstellt wird (proportional wirkende Steuerrolle), oder dadurch, dass eine Steuerrolle mit ihrer Längsachse relativ zur Transportrichtung verdreht wird (integral wirkende Steuerrolle). Entsprechend kann das bandförmige Material 11 innerhalb der unter Vakuum gesetzten Beschichtungskammer 14 stets optimal positioniert werden, so dass z.B. ein "Anecken" bzw. eine Berührung des bandförmigen Materials 11 mit Seitenwänden der Beschichtungskammer 14 bzw. des Beschichtungsteil 26 während einer Bewegung des bandförmigen Materials 11 entlang der Förderstrecke 12 verhindert wird.

Des Weiteren kann vorgesehen sein, dass innerhalb der Einlaufschleuse 20 und/oder innerhalb der Auslaufschleuse 22 weitere Bandlagenregeleinrichtungen 24.3, 24.4 angeordnet sind. Ebenfalls ist es möglich, dass eine weitere Bandlagenregeleinrichtung 24.2 - in Transportrichtung T des bandförmigen Materials 11 gesehen - stromaufwärts der Einlaufschleuse 20 angeordnet ist, und/oder dass eine weitere Bandlagenregeleinrichtung 24.5 - in Transportrichtung T des bandförmigen Materials 11 gesehen - stromabwärts der Auslaufschleuse 22 angeordnet ist. Diesbezüglich darf darauf hingewiesen werden, dass alle diese Bandlagenregeleinrichtungen Stellglieder wie vorstehend erläutert aufweisen können, um damit das bandförmige Material 11 in Bezug auf die Mitte der Förderstrecke 12 und senkrecht zur Transportrichtung T auszurichten.

In Transportrichtung T des bandförmigen Materials 11 gesehen kann stromaufwärts der Einlaufschleuse 20 eine weitere chemische Reinigungseinrichtung 42 angeordnet sein, die von dem bandförmigen Material 11 vor einem Einlaufen in die Beschichtungskammer 14 durchlaufen wird. Hierdurch werden die Oberflächen des bandförmigen Materials 11, bevor es in dem Reinigungsteil 28 (unter Vakuum) einer Feinreinigung unterzogen wird, vorbereitend gesäubert bzw. gereinigt.

Die Vakuumbeschichtungsanlage 10 umfasst zumindest eine Besäumschere 38, die - in Transportrichtung T des bandförmigen Materials 11 gesehen - stromaufwärts der Einlaufschleuse 20 angeordnet ist. Angrenzend hierzu ist zumindest ein weiterer Positionssensor 36 vorgesehen, mit dem eine Position des bandförmigen Materials 11 auf der Förderstrecke 12 in einem Bereich stromaufwärts der Beschichtungskammer 14, und damit auch im Bereich der Besäumschere 38, bestimmt werden kann. Dieser Positionssensor 36 ist ebenfalls mit der Steuerungseinrichtung 34 signaltechnisch verbunden. Entsprechend ist es mittels der Steuerungseinrichtung 34 möglich, die Besäumschere 38 in Abhängigkeit von Signalen des Positionssensors 36 zu betätigen bzw. in Aktion zu setzen.

Die signaltechnische Verbindung zwischen der Steuerungseinrichtung 34 einerseits, und den Positionssensoren 36, den Bandlagenregeleinrichtungen 24 und der Besäumschere 38 andererseits, ist in der Fig. 1 vereinfacht durch eine strichpunktierte Linie symbolisiert.

Die Besäumschere 38 dient zu dem Zweck, das bandförmige Material 11 an entweder einer Bandkante davon, oder wahlweise an beiden Bandkanten (d.h. am linken und rechten Seitenrand des bandförmigen Materials 11) zu besäumen, d.h. dort durch ein Schneiden schmaler zu machen und dadurch die Breite des bandförmigen Materials 11 senkrecht zur Transportrichtung T zu vermindern. Die Besäumschere 38 wird im Betrieb der Vakuumbeschichtungsanlage 10 und bei einer entsprechenden Bewegung des bandförmigen Materials 11 entlang der Förderstrecke 12 dann betätigt, wenn durch den Positionssensor 36 erkannt wird, dass eine Breite des bandförmigen Materials 11 von einem vorbestimmten Sollwert abweicht und z.B. infolge einer Breitung zu groß ist. Durch das Besäumen wird erreicht, dass das bandförmige Material 11 in dem Bereich stromaufwärts der Einlaufschleuse 20, und damit vor dem Einlaufen hinein in die Beschichtungskammer 14, eine gleichbleibende Breite über dessen Länge erhält, wobei diese Breite auch optimal an die Breite der Einlaufschleuse 20 angepasst ist.

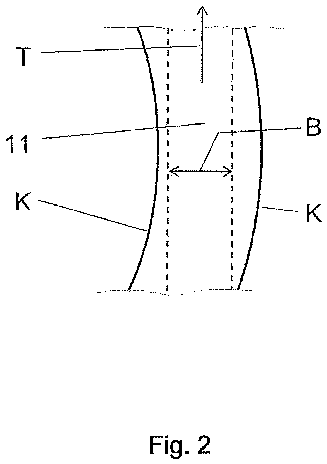

Die Fig. 2 zeigt eine Draufsicht auf das bandförmige Material 11, wobei hierin die Transportrichtung ebenfalls mit "T" veranschaulicht, jedoch zur Vereinfachung die übrigen Komponenten der Vakuumbeschichtungsanlage 10 nicht gezeigt sind. In der Darstellung von Fig. 2 hat das bandförmige Material 11 - übertrieben gezeigt - eine Säbelform, und weist jedenfalls in seiner Transportrichtung T keine gleichbleibende Breite auf.

In der Fig. 2 sind mit gestrichelten Linien die Schnittkanten symbolisiert, an denen das bandförmige Material 11 an seinen beiden Bandkanten K mittels der Besäumschere 38 besäumt, d.h. geschnitten wird. Im Ergebnis wird dadurch für das bandförmige Material 11 eine konstante Breite B über der Längenerstreckung erreicht, mit der dann das bandförmige Material 11 in der Transportrichtung T in die Beschichtungskammer 14 einläuft, nämlich wie erläutert durch die Einlaufschleuse 20.

Weitere mögliche Planheitsfehler des bandförmigen Materials 11 können durch eine Dressiergerüsteinrichtung 40 und/oder durch eine (nicht gezeigte) Streck-/Biegeeinrichtung ausgeglichen bzw. kompensiert werden, die - in Transportrichtung T des bandförmigen Materials 11 gesehen - stromaufwärts der Besäumschere 38 angeordnet ist/sind.

Durch ein Hindurchführen des bandförmigen Materials 11 durch die Beschichtungskammer 14 wird zumindest auf eine Oberfläche des bandförmigen Materials 11, vorzugsweise auf beide Oberflächen davon, eine Beschichtung aufgebracht, z.B. eine Zinkschicht. Dieses Beschichten kann innerhalb des Beschichtungsteil 26 nach dem Prinzip der PVD erfolgen. Nachdem zumindest eine Oberfläche des bandförmigen Materials 11 mit einer Beschichtung, z.B. mit einer Zinkschicht, versehen worden sind, wird das bandförmige Material 11 dann wie erläutert von der zweiten Haspeleinrichtung 12 wieder aufgewickelt.

Zur Funktionsweise der Besäumschere 38 darf angemerkt werden, dass es nach einer Ausführungsform der Erfindung möglich ist, diese Besäumschere 38 in Abhängigkeit der Signale des Positionssensors 36, der stromaufwärts dieser Besäumschere 38 angeordnet ist, erst dann betätigt wird, wenn eine Abweichung der Position und/oder der Breite des bandförmigen Materials 11 von einem vorbestimmten Wert, insbesondere in Bezug auf eine Mitte der Förderstrecke 12 erkannt wird.

Nach einer weiteren Ausführungsform der Erfindung, und in Entsprechung der Darstellung von Fig. 2, ist vorgesehen, dass - in Transportrichtung T des bandförmigen Materials 11 gesehen - stromaufwärts der Besäumschere 38 eine Bandlagenregeleinrichtung 24.2 angeordnet ist, mit der das bandförmige Material 11 in Bezug auf die Mitte der Förderstrecke 12 ausgerichtet werden kann. Die Positionierung dieser Bandlagenregeleinrichtung 24.2 erfolgt unmittelbar vor der Besäumschere 38 - dies bedeutet im Sinne der vorliegenden Erfindung, dass ein Abstand der Bandlagenregeleinrichtung 24.2 zur Besäumschere, wie erläutert in Transportrichtung T des bandförmigen Materials 11 gesehen stromaufwärts hiervon, sehr klein gewählt ist, und insbesondere zwischen der Bandlagenregeleinrichtung 24.2 und der Besäumschere 38 keine weiteren Aggregate oder dergleichen vorgesehen sind. Diesbezüglich versteht sich, dass die Bandlagenregeleinrichtung 24.2 mit dem Positionssensor 36, der- in Transportrichtung T des bandförmigen Materials 11 gesehen - ebenfalls stromaufwärts der Besäumschere 38 angeordnet ist, signaltechnisch verbunden ist. Entsprechend kann damit das bandförmige Material 11 in einem Bereich auf der Förderstrecke 12, unmittelbar bevor es in den Wirkbereich der Besäumschere 38 einläuft, durch die dort angeordnete Bandlagenregeleinrichtung 24.2 in Bezug auf eine Mitte der Förderstrecke 12 ausgerichtet werden. In dieser Weise erfüllt die besagte Bandlagenregeleinrichtung 24.2 die Funktion einer Bandmittenregelungseinheit.

Ergänzend und/oder alternativ hierzu ist es nach einer weiteren (nicht gezeigten) Ausführungsform der Erfindung möglich, die Besäumschere 38 nach Bedarf seitlich in die Förderstrecke 12 senkrecht zur Transportrichtung T ein- oder auszufahren.

Somit gelingt mit der vorliegenden Erfindung das Aufbringen einer Beschichtung auf eine bzw. die Oberfläche(n) des bandförmigen Materials 11 bei nur geringen Temperaturen, ohne dass die Materialeigenschaften des bandförmigen Materials 11 verändert bzw. beeinträchtigt werden. Dies ist insbesondere dann von Vorteil, wenn es sich bei dem bandförmigen Material um ein Stahlband insbesondere in Form von Warmband handelt, welches einen Gefügeanteil von mindestens 10% Martensit aufweist.

### Bezugszeichenliste

- 10: Vakuumbeschichtungsanlage
- 11: bandförmiges Material
- 12: Förderstrecke
- 14: Beschichtungskammer
- 16: Einlassbereich
- 18: Auslassbereich
- 20: Einlaufschleuse
- 22: Auslaufschleuse
- 24: Bandlagenregeleinrichtung
- 24.2: Bandlagenregeleinrichtung
- 24.3: Bandlagenregeleinrichtung
- 24.4: Bandlagenregeleinrichtung
- 26: Beschichtungsteil
- 28: Reinigungsteil
- 34: Steuerungseinrichtung
- 36: Positionssensor
- 38: Besäumschere
- 40: Dressiergerüsteinrichtung
- 42: chemische Reinigungseinrichtung
- 44: Speicher
- 46: erste Haspeleinrichtung (Einlauf)
- 48: zweite Haspeleinrichtung (Auslauf)
- B: konstante Breite (des bandförmigen Materials 11)
- K: Bandkante(n) (des bandförmigen Materials 11)
- T: Transportrichtung (für das bandförmige Material 11)

## Patentansprüche

1. Vakuumbeschichtungsanlage (10) zum Beschichten eines bandförmigen Materials (11) insbesondere aus Metall, umfassend
eine Förderstrecke (12) mit Transportmitteln insbesondere in Form von Walzen, auf denen das bandförmige Material (11) in einer Transportrichtung (T) bewegbar ist, wobei die Transportmittel der Förderstrecke (12) derart ausgebildet sind, dass darauf das bandförmige Material aus Metall (11) mit seiner Breitenerstreckung in horizontaler Ausrichtung in der Transportrichtung (T) bewegbar ist, und
eine Beschichtungskammer (14), in der Vakuum erzeugbar ist, wobei die Beschichtungskammer (14) einen Einlassbereich (16) und einen Auslaufbereich (18) aufweist und dadurch von dem bandförmigen Material (11) entlang bzw. auf der Förderstrecke (12) in der Transportrichtung (T) durchlaufbar ist,
wobei - in Transportrichtung (T) des bandförmigen Materials (11) gesehen - stromaufwärts der Beschichtungskammer (14) zumindest eine Besäumschere (38) angeordnet ist, mit der das bandförmige Material (11) an zumindest einer Bandkante (K) besäumt wird, **dadurch gekennzeichnet,**
**dass** die Besäumschere (38) derart eingerichtet ist, um für das bandförmige Material (11) über dessen Längenerstreckung eine konstante Breite (B) zu erzeugen, und
**dass** - in Transportrichtung (T) des bandförmigen Materials (11) gesehen - stromaufwärts der Besäumschere (38) eine Bandlagenregeleinrichtung (24.2) angeordnet ist, mit der das bandförmige Material (11) in Bezug auf die Mitte der Förderstrecke (12) ausrichtbar ist.

2. Vakuumbeschichtungsanlage (10) nach Anspruch 1, **gekennzeichnet durch** zumindest einen Positionssensor (36), mit dem eine Position des bandförmigen Materials (11) auf der Förderstrecke (12) in einem Bereich - in Transportrichtung (T) des bandförmigen Materials (11) gesehen - stromaufwärts der Beschichtungskammer (14) bestimmbar ist.

3. Vakuumbeschichtungsanlage (10) nach Anspruch 2, **dadurch gekennzeichnet, dass** eine Steuerungseinrichtung (34) vorgesehen ist, mittels der die Besäumschere (38) in Abhängigkeit von Signalen des Positionssensors betätigbar ist.

4. Vakuumbeschichtungsanlage (10) nach einem der vorhergehenden Ansprüche, **dadurch gekennzeichnet, dass** die Besäumschere (38) derart eingerichtet ist, um damit das bandförmige Material (11) an beiden Bandkanten (K) zu besäumen.

5. Vakuumbeschichtungsanlage (10) nach einem der vorhergehenden Ansprüche, **dadurch gekennzeichnet, dass** - in Transportrichtung (T) des bandförmigen Materials (11) gesehen - stromaufwärts der Besäumschere (38) eine Dressiergerüsteinrichtung (40) und/oder eine Streck-/Biegeeinrichtung angeordnet ist, durch die das bandförmige Material (11) hindurchgeführt wird, um für das bandförmige Material (11) eine gewünschte Planheit zu erzeugen.

6. Verfahren zum Beschichten eines bandförmigen Materials (11) insbesondere aus Metall, bei dem das bandförmige Material (11) mit seiner Breitenerstreckung in horizontaler Ausrichtung über eine Förderstrecke (12) in einer Transportrichtung (T) bewegt und innerhalb einer Beschichtungskammer (14), in der ein Vakuum angelegt ist, vakuumbeschichtet wird,
wobei das bandförmige Material (11) - in Transportrichtung (T) des bandförmigen Materials (11) gesehen - stromaufwärts der Beschichtungskammer (14) mit zumindest einer Besäumschere (38) an zumindest einer Bandkante (K) besäumt wird,
**dadurch gekennzeichnet,**
**dass** für das bandförmige Material (11) mit der Besäumschere (38) eine konstante Breite (B) erzeugt wird, und
**dass** das bandförmige Material (11) durch eine Bandlagenregeleinrichtung (24.2), die - in Transportrichtung (T) des bandförmigen Materials (11) gesehen - stromaufwärts der Besäumschere (38) angeordnet ist, in Bezug auf die Mitte der Förderstrecke (12) ausgerichtet wird.

7. Verfahren nach Anspruch 6, **dadurch gekennzeichnet, dass** das bandförmige Material (11) mit der Besäumschere (38) an beiden Bandkanten (K) besäumt wird.

## Claims

1. Vacuum-coating system (10) for coating a strip-shaped material (11), in particular of metal, comprising
a conveying section (12) with transport means, in particular in the form of rollers, on which the strip-shaped material (11) is movable in a transport direction (T), wherein the transport means of the conveying section (12) are so constructed that the strip-shaped material (11) of metal is movable thereon in the transport direction (T) with its width dimension in horizontal orientation, and
a coating chamber (14) in which a vacuum can be generated, wherein the coating chamber (14) has an inlet area (16) and an outlet area (18) and can thereby be transited by the strip-shaped material (11) along or on the conveying section (12) in the transport direction (T),
wherein as viewed in the conveying direction (T) of the strip-shaped material (11) at least one trimming shears (38), by which the strip shaped material (11) is trimmed at at least one strip edge (K), is arranged upstream of the coating chamber (14),
**characterised in that**
the trimming shears (38) are arranged in such a way as to produce a constant width (B) for the strip-shaped material (11) over the length dimension thereof, and
as viewed in transport direction (T) of the strip-shaped material (11) a strip position regulating device (24) by which the strip-shaped material (11) can be aligned with respect to the centre of the conveying section (12) is arranged upstream of the trimming shears (38).

2. Vacuum-coating system (10) according to claim 1, **characterised by** at least one position sensor (36) by which a position of the strip-shaped material (11) on the conveying section (12) can be determined in an area upstream of the coating chamber (14) as seen in transport direction (T) of the strip-shaped material (11).

3. Vacuum-coating system (10) according to claim 2, **characterised in that** a control device (34) by means of which the trimming shears (38) can be actuated as a function of signals of the position sensor is provided.

4. Vacuum-coating system (10) according to any one of the preceding claims, **characterised in that** the trimming shears (38) are so arranged as to thereby trim the strip-shaped material (11) at both strip edges (K).

5. Vacuum-coating system (10) according to any one of the preceding claims, **characterised in that**, as seen in transport direction (T) of the strip-shaped material (11), a skin pass mill (40) and/or a stretching/bending device through which the strip-shaped material (11) is conducted in order to produce a desired flatness for the strip-shaped material (11) is or are arranged upstream of the trimming shears (38).

6. Method of coating a strip-shaped material (11), in particular of metal, in which the strip-shaped material (11) is moved over a conveying section (12) in a transport direction (T) with its width dimension in horizontal orientation and is vacuum-coated within a coating chamber (14) in which a vacuum prevails,
wherein the strip-shaped material (11) is trimmed upstream of the coating chamber (14), as viewed in transport direction (T) of the strip-shaped material (11)), by at least one trimming shears (38) at at least one strip edge (K),
**characterised in that**
a constant width (B) for the strip-shaped material (11) is produced by the trimming shears (38) and
the strip-shaped material is oriented with respect to the centre of the conveying section (12) by a strip position regulating device (24.2) arranged upstream of the trimming shears (12) as seen in transport direction (T) of the strip-shaped material (11).

7. Method according to claim 6, **characterised in that** the strip-shaped material (11) is trimmed at both strip edges (K) by the trimming shears (38).

## Revendications

1. Installation de dépôt sous vide (10) destinée à l'enduction d'une matière en forme de bande (11) en particulier en métal, qui comprend :
un tronçon de transport (12) qui est équipé de moyens de transport, en particulier sous la forme de rouleaux, sur lesquels la matière en forme de bande (11) peut être mise en mouvement dans une direction de transport (T) ; dans laquelle les moyens de transport du tronçon de transport (12) sont réalisés d'une manière telle que la matière en forme de bande réalisée en métal (11) peut être mise en mouvement sur les rouleaux en question avec son étendue en largeur dans une orientation horizontale dans la direction de transport (T) ; et
une chambre d'enduction (14) dans laquelle un vide peut être généré; dans laquelle la chambre d'enduction (14) présente une zone d'entrée (16) et une zone de sortie (18), si bien qu'elle peut être traversée par la matière en forme de bande (11) le long du tronçon de transport (12) dans la direction de transport (T), respectivement sur le tronçon en question ;
dans laquelle - lorsque l'on regarde dans la direction de transport (T) de la matière en forme de bande (11) - au moins une cisaille à rogner (38) est disposée en amont par rapport à la chambre d'enduction (14), avec laquelle la matière en forme de bande (11) est soumise à un rognage à au moins un bord (K) de la bande, **caractérisée**
**en ce que** la cisaille à rogner (38) est conçue de manière à générer une largeur constante (B) pour la matière en forme de bande (11) sur l'étendue en longueur de cette dernière ; et
**en ce que** - lorsque l'on regarde dans la direction de transport (T) de la matière en forme de bande (11) - un mécanisme de réglage de la position de la bande (24.2) est disposé en amont par rapport à la cisaille à rogner (38), avec lequel la matière en forme de bande (11) peut être orientée par rapport au milieu du tronçon de transport (12).

2. Installation de dépôt sous vide (10) selon la revendication 1, **caractérisée par** au moins un capteur de la position (36), avec lequel on peut déterminer une position de la matière en forme de bande (11) sur le tronçon de transport (12) dans une zone - lorsque l'on regarde dans la direction de transport (T) de la matière en forme de bande (11) - qui est située en amont par rapport à la chambre d'enduction (14).

3. Installation de dépôt sous vide (10) selon la revendication 2, **caractérisée en ce que** l'on prévoit un mécanisme de commande (34) au moyen duquel la cisaille à rogner (38) peut être activée en fonction de signaux émis par le capteur de la position.

4. Installation de dépôt sous vide (10) selon l'une quelconque des revendications précédentes, **caractérisée en ce que** la cisaille à rogner (38) est conçue de façon à rogner avec la cisaille en question la matière en forme de bande (11) aux deux bords (K) de la bande.

5. Installation de dépôt sous vide (10) selon l'une quelconque des revendications précédentes, **caractérisée en ce que** - lorsque l'on regarde dans la direction de transport (T) de la matière en forme de bande (11) - un mécanisme (40) sous la forme d'une cage de dressage et/ou un mécanisme d'étirage/de flexion est/sont disposés en amont par rapport à la cisaille à rogner (38), à travers lequel/lesquels est guidée la matière en forme de bande (11) dans le but de générer une planéité désirée pour la matière en forme de bande (11).

6. Procédé destiné à l'enduction d'une matière en forme de bande (11), en particulier en métal, dans lequel on met la matière en forme de bande (11) avec son étendue en largeur dans une orientation horizontale en mouvement par-dessus un tronçon de transport (12) dans une direction de transport (T) et on la soumet à un dépôt sous vide à l'intérieur d'une chambre d'enduction (14) dans laquelle un vide est appliqué ;
dans lequel la matière en forme de bande (11) - lorsque l'on regarde dans la direction de transport (T) de la matière en forme de bande (11) - est soumise à un rognage en amont de la chambre d'enduction (14) avec au moins une cisaille à rogner (38) à au moins un bord (K) de la bande ;
**caractérisé**
**en ce que** l'on génère, pour la matière en forme de bande (11), avec la cisaille à rogner (38) une largeur constante (B) ; et
**en ce que** l'on oriente la matière en forme de bande (11) par l'intermédiaire d'un mécanisme de réglage de la position de la bande (24.2) qui est disposé - lorsque l'on regarde dans la direction de transport (T) de la matière en forme de bande (11) - en amont par rapport à la cisaille à rogner (38).

7. Procédé selon la revendication 6, **caractérisé en ce que** l'on soumet la matière en forme de bande (11) à un rognage avec la cisaille à rogner (38) aux deux bords (K) de la bande.
